(19) **Europäisches Patentamt**
European Patent Office
Office européen des brevets

(11) **EP 1 540 818 B1**

(12) **EUROPÄISCHE PATENTSCHRIFT**

(45) Veröffentlichungstag und Bekanntmachung des Hinweises auf die Patenterteilung:
**04.11.2009 Patentblatt 2009/45**

(21) Anmeldenummer: **03747831.0**

(22) Anmeldetag: **05.09.2003**

(51) Int Cl.:
*H03H 7/32* (2006.01)    *H03G 9/18* (2006.01)
*H04B 1/64* (2006.01)    *H03H 7/12* (2006.01)

(86) Internationale Anmeldenummer:
**PCT/DE2003/002956**

(87) Internationale Veröffentlichungsnummer:
**WO 2004/030209 (08.04.2004 Gazette 2004/15)**

(54) **SCHALTKREIS-ANORDNUNG UND SIGNALVERARBEITUNGS-VORRICHTUNG**

CIRCUIT ARRANGEMENT AND SIGNAL PROCESSING DEVICE

CIRCUITERIE DE COMMUTATION ET DISPOSITIF DE TRAITEMENT DES SIGNAUX

(84) Benannte Vertragsstaaten:
**DE FR GB**

(30) Priorität: **20.09.2002 DE 10243869**

(43) Veröffentlichungstag der Anmeldung:
**15.06.2005 Patentblatt 2005/24**

(73) Patentinhaber: **Infineon Technologies AG**
**81669 München (DE)**

(72) Erfinder: **HEMMERT, Werner**
**85368 Moosburg (DE)**

(74) Vertreter: **Viering, Jentschura & Partner**
**Postfach 22 14 43**
**80504 München (DE)**

(56) Entgegenhaltungen:
**US-A- 2 606 969     US-A- 3 808 540**
**US-A- 3 903 485     US-A- 5 276 739**
**US-A- 5 325 184**

**Beschreibung**

Die Erfindung betrifft eine Schaltkreis-Anordnung und eine Signalverarbeitungs-Vorrichtung.

Schallsignale weisen einen hohen Intensitätsbereich auf, das heißt eine hohe Dynamik von bis zu 120dB. Die Geräuschkulisse einer ländlichen Gegend bei Nacht entspricht ungefähr 20dB, wohingegen ein Gewehrschuss in der Nähe des Entstehens einen Schallpegel von ungefähr 140dB aufweist.

Aufgrund von Adaptionsprozessen im menschlichen Innenohr, bei denen die sogenannten äußeren Haarzellen eine wichtige Rolle spielen, erreicht das normale Gehör sowohl eine hohe Empfindlichkeit bei niedrigen Schallpegeln als auch eine hohe Toleranz bei hohen Schallpegeln. Der Schallpegel ist eine physikalische Größe, welche ein Maß ist für die Intensität des Schalls. Das Gehör passt seine Verstärkung dem aktuellen Schallpegel an und ist daher in der Lage, einen großen Dynamikbereich an Schallpegeln zwischen als leise empfundenem Schall und als laut empfundenem Schall abzudecken. Anschaulich wird ein großer Schallpegelbereich auf einen kleinen wahrnehmbaren Bereich zusammengedrückt. In diesem Zusammenhang spricht man von Dynamikkompression.

Bei der Kodierung von Sprache in Aktionspotentiale des Hörnerven wird der große Dynamikbereich der Schallsignale (bis zu 120dB) auf den begrenzten dynamischen Bereich der Sinneszellen bzw. eines neuronalen Systems (etwa 40dB) komprimiert.

Spracherkennungs-Systeme, Hörgeräte und Audio-Datenkomprimierung sind wirtschaftlich interessante Gebiete. Grundlagen der automatischen Spracherkennung sind beispielsweise [1] zu entnehmen.

In einem bekannten Spracherkennungs-System wird eine schnelle Fourier-Transformation ("Fast Fourier Transformation", FFT) zur spektralen Analyse von Schallsignalen verwendet. Anschließend wird das erhaltene Amplitudenspektrum logarithmiert. Dies entspricht anschaulich einer Dynamikkompression mit logarithmischer Kennlinie.

Bei einer solchen schnellen Fourier-Transformation wird typischerweise ein Zeitfenster einer vorgegebenen Länge verwendet, was zu einer beschränkten Frequenz- und Zeitauflösung führt. Wird, wie in der Spracherkennung üblich, nur das Betragsspektrum verwendet, ist die Zeitauflösung durch die Länge des verwendeten Zeitfensters limitiert. Problematisch bei der Verwendung eines Zeitfensters fest vorgegebener Größe ist, dass bei einer Veränderung des Spektrums nach der Rücktransformation ein Fehler erhalten wird, der auf der Endlichkeit des Zeitfensters beruht.

[3] offenbart eine Vorrichtung zum Verringern der scheinbaren Lautstärke eines Ausgabesignals in einem Rundfunksystem, die ein Frequenz-selektives Verstärkungsverringerungs-Netwerk aufweist.

[4] offenbart eine Schaltungsanordnung zur Kompression des dynamischen Bereichs eines Eingabesignals.

Der Erfindung liegt das Problem zugrunde, eine Schaltkreis-Anordnung und eine Signalverarbeitungs-Vorrichtung bereitzustellen, mit denen eine verbesserte Dynamikkompression ermöglicht ist.

Das Problem wird gelöst durch eine Schaltkreis-Anordnung und durch eine Signalverarbeitungs-Vorrichtung mit den Merkmalen gemäß den unabhängigen Patentansprüchen.

Die Schaltkreis-Anordnung weist einen Resonator-Schaltkreis zum Generieren eines Ausgabesignals aus einem Eingabesignal auf. Der Resonator-Schaltkreis enthält eine Kapazität und eine Induktivität, einen Eingang, an dem das Eingabesignal bereitstellbar ist und einen Ausgang, an dem das Ausgabesignal bereitstellbar ist. Ferner weist die Schaltkreis-Anordnung einen Steuer-Schaltkreis zum Steuern oder Regeln der Güte des Resonator-Schaltkreises auf, wobei der Steuer-Schaltkreis derart eingerichtet ist, dass er die Güte des Resonator-Schaltkreises abhängig von der Amplitude, vorzugsweise abhängig von dem Signalverlauf der Signalamplitude, des Eingabesignals und/oder des Ausgabesignals steuert oder regelt.

Mit anderen Worten wird vorzugsweise die Güte abhängig von dem Signalverlauf der Signalamplitude gesteuert oder geregelt, was anschaulich den Vorteil mit sich bringt, dass die Zeitabhängigkeit des Eingabesignals und/oder des Ausgabesignals selbst auf die Zeitabhängigkeit der Güte abgebildet wird, so dass ein quasi-instantanes, verzögerungsfreies Steuern der Güte ermöglicht wird. Jedoch ist zu betonen, dass das Steuern der Güte abhängig von dem Signalverlauf der Signalamplitude optional ist, es ist auch möglich, die Güte abhängig von der Amplitude zu steuern oder zu regeln.

Darüber hinaus ist erfindungsgemäß eine Signalverarbeitungs-Vorrichtung mit einer Schaltkreis-Anordnung mit den oben genannten Merkmalen bereitgestellt. Ferner enthält die Signalverarbeitungs-Vorrichtung eine Weiterverarbeitungs-Einheit zum Weiterverarbeiten des Ausgabesignals.

Eine Grundidee der Erfindung ist darin zu sehen, dass die Güte des Resonator-Schaltkreises basierend auf der Amplitude des Eingabe- oder Ausgabesignals eingestellt wird. Weist eines dieser Signale eine sehr hohe Amplitude auf, so kann mittels des Steuer-Schaltkreises die Güte des Resonator-Schaltkreises derart stark verringert werden, dass das Signal stark gedämpft wird. Dagegen kann bei einem Signal einer geringen Amplitude die Güte derart erhöht werden, dass ein nur sehr schwach gedämpftes Signal an dem Ausgang der Schaltkreis-Anordnung bereitgestellt wird.

Anschaulich wird erfindungsgemäß zum Durchführen einer Dynamikkompression die Tatsache verwendet, dass ein Resonator-Schaltkreis nahe seiner Resonanzfrequenz als ausreichend stabiler Verstärker wirkt (Resonanzüberhöhung).

Unter der Güte eines Resonator-Schaltkreises wird insbesondere das Verhältnis einer Amplitude eines Ausgabesignals bei oder nahe der Resonanzfrequenz des Resonator-Schaltkreises zu der entsprechenden Amplitude bei einer von der Resonanzfrequenz stark unterschiedlichen Frequenz verstanden. Die Güte eines Resonator-Schaltkreises hängt von dessen ohmschen Widerstand ab, so dass die Güte beispielsweise mittels Steuerns oder Regelns des ohmschen Widerstands des Resonator-Schaltkreises einstellbar ist.

In einem Szenario, in dem die Güte des Resonator-Schaltkreises basierend auf der Amplitude des in den Resonator-Schaltkreis eingeführten Eingabesignals eingestellt wird, kann die Funktionalität des Steuer-Schaltkreises als ein "Steuern" bezeichnet werden. Wird dagegen die Güte des Steuer-Schaltkreises basierend auf der Amplitude des Ausgabesignals eingestellt, so erfüllt der Steuer-Schaltkreis eine "Regelungs"-Funktionalität, da er ein rückgekoppeltes Anpassen der Güte durchführt.

Mit der erfindungsgemäßen Schaltkreis-Anordnung ist eine sichere und effektive Dynamikkompression eines Eingabesignals im Zeitbereich ermöglicht, ohne dass die Nachteile einer Fourier-Transformation auftreten. Insbesondere entfallen die bei einer Fourier-Transformation gemäß dem Stand der Technik auftretenden Probleme mit einem endlichen Zeitfenster.

Darüber hinaus wird erfindungsgemäß ein dynamik komprimiertes Ausgangssignal generiert, das z.B. im Vergleich zu der Rücktransformation des logarithmierten Fourierspektrums deutlich geringere störende Signalverzerrung aufweist.

Gemäß der Erfindung ist eine ausreichend starke und intensitätsselektive (z.B. nichtlineare) Dämpfung eines Eingabesignals mittels selektiven Verringerns der Güte des Resonator-Schaltkreises ermöglicht.

Anschaulich kann die Schaltkreis-Anordnung als Filter-Schaltkreis aufgefasst werden, wobei basierend auf dem Wert der Induktivität L und der Kapazität C des Resonator-Schaltkreises der Frequenzbereich festgelegt ist, für welchen der Resonator-Schaltkreis durchlässig ist. Somit ist mittels Einstellens der Werte L, C eine einfache Möglichkeit geschaffen, den Frequenz-Schwerpunkt des transmittierbaren Intervalls des Resonator-Schaltkreises einzustellen. Die Breite der Resonanzkurve des Resonator-Schaltkreises ist insbesondere mittels Einstellens seiner Güte justierbar. Der Resonator-Schaltkreis in seiner erfindungsgemäßen Verschaltung kann als Filter mit nichtlinearer Dämpfung angesehen werden, mit dem eine im Prinzip beliebig hohe Dynamikkompression erreicht werden kann. Aufgrund einer ausreichend schmalbandigen Verarbeitung können auch Verzerrungen, die durch eine zu starke Nichtlinearität entstehen können, ausreichend gering gehalten werden.

Die Schaltkreis-Anordnung als Filter kann einen Resonator-Schaltkreis zweiter Ordnung enthalten, wobei die Dämpfung nichtlinear mit steigendem Schallpegel ansteigt. Bei einer passiven Realisierung der Schaltkreis-Anordnung, das heißt bei einer Verwendung passiver Bauelemente (Spule L, Kondensator C, ohmscher Widerstand R) kann eine stabile Schaltung erhalten werden (im Gegensatz zu Systemen, die einen aktiven, rückgekoppelten Verstärker benötigen).

Anstelle einer schnellen Fourier-Transformation (FFT) wird erfindungsgemäß eine, beispielsweise analoger, Filterbank verwendet, anstelle einer Logarithmierung wird eine nichtlineare Dämpfung eines Eingabesignals basierend auf dem Schallpegel eines Signals durchgeführt.

Bevorzugte Weiterbildungen der Erfindung ergeben sich aus den abhängigen Ansprüchen.

Der Resonator-Schaltkreis kann einen mittels des Steuer-Schaltkreises steuerbaren (bzw. regelbaren) ohmschen Widerstand aufweisen. Ein solcher steuerbarer oder regelbarer ohmscher Widerstand ist eine einfache Schaltkreis-Komponente, mittels welcher die Funktionalität des Regelns der Güte des Resonator-Schaltkreises mit geringem Aufwand und genau und stabil erfüllt werden kann.

Das Eingabesignal kann zwischen einem ersten Anschluss des ohmschen Widerstands und einem ersten Anschluss der Kapazität bereitgestellt sein. Das Ausgabesignal kann zwischen dem ersten Anschluss der Kapazität und einem zweiten Anschluss der Kapazität bereitgestellt sein. Ein zweiter Anschluss des ohmschen Widerstands kann mit einem ersten Anschluss der Induktivität und ein zweiter Anschluss der Induktivität kann mit einem zweiten Anschluss der Kapazität gekoppelt sein.

Der Steuer-Schaltkreis kann derart eingerichtet sein, dass er die Güte des Resonator-Schaltkreises basierend auf einer Boltzmann-Funktion steuert, in welcher die Amplitude des Ausgabesignals als Parameter enthalten ist. Eine Boltzmann-Funktion ist bei geeigneter Wahl der darin enthaltenen Parameter gut geeignet, die Empfindlichkeitskurve der äußeren Haarsinneszellen im menschlichen Innenohr anzunähern. Eine besonders gute Beschreibung dieser biologischen Abhängigkeit kann durch eine Boltzmann-Funktion zweiter Ordnung beschrieben werden. Dadurch ist es möglich, die Empfindlichkeitskurve im menschlichen Ohr anzunähern, was für Anwendungen der Schaltkreis-Anordnung im medizinischen Bereich (beispielsweise für ein Hörgerät) vorteilhaft ist.

Der Steuer-Schaltkreis kann derart eingerichtet sein, dass er die Güte des Resonator-Schaltkreises in Abhängigkeit von der Amplitude des Ausgabesignals basierend auf einer für ein Ohr eines Menschen ermittelten Empfindlichkeitscharakteristik einstellt. Um die Empfindlichkeitscharakteristik im Innenohr eines Menschen besonders gut mittels einer erfindungsgemäßen Schaltkreis-Anordnung nachzubilden, kann eine beispielsweise experimentell oder theoretisch ermittelte Empfindlichkeitscharakteristik des menschlichen Ohrs in der Form einer Datei oder Tabelle für den Steuer-Schaltkreis zugänglich abgelegt sein. In diesem Fall kann der Steuer-Schaltkreis die Güte des Resonator-Schaltkreises derart steuern oder regeln, dass die darin abgelegte biologische Empfindlichkeitscharakteristik angenähert wird.

Der Steuer-Schaltkreis kann derart eingerichtet sein, dass er die Güte des Resonator-Schaltkreises umso geringer einstellt, je höher die Amplitude des Ausgabesignals ist.

Der Steuer-Schaltkreis kann ferner derart eingerichtet sein; dass er die Güte des Resonator-Schaltkreises in einer nichtlinearen Abhängigkeit von der Amplitude des Ausgabesignals einstellt. D.h., dass Signalbereiche großer Amplitude überproportional stark gegenüber Signalbereichen kleiner Amplitude gedämpft werden. Somit kann auch bei einem extrem hohen Bereich von Schallpegeln in einem Eingabesignal eine Komprimierung auf einen ausreichend schmalen Bereich bei dem Ausgabesignal erreicht werden.

Der Steuer-Schaltkreis kann derart eingerichtet sein, dass er die Güte des Resonator-Schaltkreises derart einstellt, dass die Amplitude des Ausgabesignals innerhalb eines vorbestimmten Intervalls ist. Für bestimmte Anwendungen kann es vorteilhaft sein, die Amplitude eines Ausgabesignals auf jeden Fall innerhalb eines vorbestimmten Intervalls zu halten. Dies kann beispielsweise im Rahmen der Datenkomprimierung wichtig sein, wenn ein Signal mit einer hohen Intensitätsschwankung mit möglichst wenig Quantisierungsstufen erfasst werden soll. In diesem Fall kann der Steuer-Schaltkreis derart eingerichtet sein, dass er die Güte des Resonator-Schaltkreises derart steuert oder regelt, dass das Ausgabesignal innerhalb des vorbestimmten Intervalls liegt.

Die Schaltkreis-Anordnung kann eine Mehrzahl von in Serie geschalteten Resonator-Schaltkreisen aufweisen, wobei ein Ausgabesignal eines jeweils vorgeschalteten Resonator-Schaltkreises den ihm jeweils nachgeschalteten Resonator-Schaltkreis als Eingabesignal bereitstellbar ist.

Gemäß dieser besonders vorteilhaften Ausgestaltung ist anschaulich eine Filterbank mit einer Hintereinander-Schaltung aus mehreren Resonator-Schaltkreisen geschaffen, wodurch die Dynamikkompression auf einen noch größeren Dynamikbereich ausgeweitet werden kann. Im Prinzip kann eine ausreichend starke Dynamikkompression (z.B. 60dB) bereits mit einer Filterstufe (d.h. mit einem Resonator-Schaltkreis) mit einer sehr hohen Güte Q (z.B. Q=1000, die bei hohen Pegeln auf eine Güte von Q=1 reduziert wird) erfolgen. Eine solche Schaltkreis-Anordnung ist allerdings sehr schmalbandig (beispielsweise 0.1% der Resonanzfrequenz des Resonator-Schaltkreises). Mittels Kaskadierens mehrerer Filter (z.B. drei hintereinander geschaltete Filter) mit einer relativ geringen Güte Q (z.B. Q=10, so dass $Q^3$=1000) lässt sich gemäß der Erfindung ebenfalls eine ausreichend starke Dynamikkompression (z.B. von 60dB) realisieren. Die nicht zu hohe Einzel-Güte von jedem dieser Filter bringt den vorteilhaften Effekt mit sich, dass aufgrund der aus der geringeren Güte resultierenden erhöhten Bandbreite der einzelnen Filter ein größerer Frequenzbereich der Filter abgedeckt wird und gleichzeitig das Impulsverhalten der Filter verbessert wird, d.h. die Ein- und Ausschwingzeit des Systems ist wesentlich geringer.

Die hintereinander geschalteten Resonator-Schaltkreise können anschaulich miteinander direkt verkoppelt sein derart, dass die Ausgabespannung eines vorgeschalteten Resonator-Schaltkreises gleich der Eingabespannung des ihm nachgeschalteten Resonator-Schaltkreises ist und dass der (im Betrieb in der Regel von Null verschiedene) Ausgabestrom eines vorgeschalteten Resonator-Schaltkreises gleich dem Eingabestrom des ihm nachgeschalteten Resonator-Schaltkreises ist. Hierfür ist die Schaltkreis-Anordnung in der Regel von einem Zwischenelement zwischen vor- und nachgeschaltetem Resonator-Schaltkreisen frei. Dies ist mittels einer Schaltkreis-Anordnung realisierbar, bei welcher der zweite Anschluss der Spule eines vorgeschalteten Resonator-Schaltkreises mit dem ersten Anschluss des ohmschen Widerstands des dem vorgeschalteten Resonator-Schaltkreis nachgeschalteten Resonator-Schaltkreises gekoppelt ist.

Alternativ können die hintereinander geschalteten Resonator-Schaltkreise anschaulich von einer unmittelbaren Kopplung frei sein, d.h. voneinander in gewisser Weise entkoppelt sein, insbesondere unter Zwischenschalten eines Zwischenelements zwischen Ausgabe eines vorgeschalteten und Eingabe eines nachgeschalteten Resonator-Schaltkreises. Dies ist vorzugsweise derart realisiert, dass die Ausgabespannung eines vorgeschalteten Resonator-Schaltkreises gleich der Eingabespannung des ihm nachgeschalteten Resonator-Schaltkreises ist und dass der Ausgabestrom eines vorgeschalteten Resonator-Schaltkreises gleich Null ist. Der Eingabestrom des nachgeschalteten Resonator-Schaltkreises ergibt sich im Wesentlichen nur aus der Impedanz des dieses Resonator-Schaltkreises. Bei einer derartigen Schaltkreis-Anordnung ist als Zwischenelement vorzugsweise ein Operationsverstärker (als Impedanzwandler) zwischen einem vorgeschalteten Resonator-Schaltkreis und dem ihm nachgeschalteten Resonator-Schaltkreis vorgesehen. Ein erster Eingang des Operationsverstärkers ist mit dem zweiten Anschluss der Spule des vorgeschalteten Resonator-Schaltkreises gekoppelt. Ein zweiter Eingang des Operationsverstärkers ist mit einem Ausgang des Operationsverstärkers rückgekoppelt und ist mit dem ersten Anschluss des ohmschen Widerstands des dem vorgeschalteten Resonator-Schaltkreis nachgeschalteten Resonator-Schaltkreises gekoppelt.

Zur Reduktion der Rechenleistung kann die Güte aller in Serie geschalteter Resonator-Schaltkreise identisch eingestellt sein. In diesem Fall ist die von dem Steuer-Schaltkreis beanspruchte Rechenleistung besonders gering gehalten, da für alle Resonator-Schaltkreise eine gemeinsame Güte ermittelt und eingestellt wird, d.h. alle Filterparameter identisch sind. Wird eine Schaltkreis-Anordnung mit einer besonders hohen Qualitätsanforderung benötigt, so kann alternativ die Güte von unterschiedlichen in Serie geschalteten Resonator-Schaltkreisen zum Zwecke einer Optimierung unterschiedlich eingestellt werden. Bei einer solchen Schaltkreis-Anordnung ist somit die Güte von jedem der in Serie geschalteten Resonator-Schaltkreise individuell eingestellt.

Die Schaltkreis-Anordnung weist vorzugsweise eine Mehrzahl von parallel geschalteten Zweigen auf, wobei jeder Zweig einen Resonator-Schaltkreis oder mehrere in Serie geschaltete Resonator-Schaltkreise aufweist. In diesem Fall ist die Güte eines jeweiligen Resonator-Schaltkreises mittels des Steuer-Schaltkreises steuerbar bzw. regelbar.

Gemäß dieser besonders vorteilhaften Weiterbildung der Erfindung sind anschaulich mehrere parallel geschaltete Zweige von Resonator-Schaltkreisen vorgesehen, wobei in jedem Zweig eine Mehrzahl von Resonator-Schaltkreisen hintereinandergeschaltet sein kann.

Vorzugsweise ist der mindestens eine Resonator-Schaltkreis eines jeweiligen Zweigs derart eingerichtet, dass er für einen jeweiligen Frequenzbereich des Eingabesignals durchlässig ist derart, dass die Zweige gemeinsam für ein zusammenhängendes Frequenzintervall durchlässig sind. Der Frequenzbereich, für den das menschliche Gehör sensitiv ist, liegt ungefähr zwischen 20Hz und 20kHz. Um diesen Hörfrequenzbereich abzudecken, sind in der parallelen Anordnung von Resonator-Schaltkreisen in unterschiedlichen Kanälen die Frequenzbereiche transmittierbarer Signale in der Regel unterschiedlich. Der Frequenzbereich transmittierbarer Signale in einem Resonator-Schaltkreis ist eine Verteilungskurve um die Resonanzfrequenz herum mit einer gewissen Halbwertsbreite. Die Resonanzfrequenz ist anschaulich mittels Einstellens der Werte L, C des Resonator-Schaltkreises möglich, die Halbwertsbreite ist mittels Einstellens der jeweiligen Güte justierbar. Setzt man die unterschiedlichen Frequenz-Durchlassbereiche der unterschiedlichen Zweige von Resonator-Schaltkreisen zusammen, so ergibt sich ein vorzugsweise zusammenhängendes Frequenzintervall, mittels welchem der Sensitivitätsbereich des menschlichen Gehörs oder ein sonstiger Frequenzbereich von Interesse erfassbar ist.

Vorzugsweise sind die Frequenzbereiche, für die unterschiedliche Zweige durchlässig sind, zumindest teilweise einander überlappend. In diesem Fall ist sichergestellt, dass alle Frequenzen erfasst werden, und es ist ein Zusammensetzen der Signalkomponenten einzelner Zweige möglich.

Vorzugsweise ist der Frequenzbereich, für den ein jeweiliger Zweig durchlässig ist, mittels Einstellens des Werts der Kapazität und/oder der Induktivität des mindestens einen Resonator-Schaltkreises des Zweigs vorgebbar. Dies beruht darauf, dass die Resonanzfrequenz eines Resonator-Schaltkreises von den Werten der Induktivität und der Kapazität abhängt.

Vorzugsweise ist die Schaltkreis-Anordnung der Erfindung zum Verarbeiten eines akustischen Signals als Eingabesignal eingerichtet. In diesem Fall eignet sich die Schaltkreis-Anordnung der Erfindung für einen Einsatz in einem Sprachverarbeitungs-System. Ein solches kann beispielsweise auf pulsenden neuronalen Netzwerken beruhen, welche auf eine Reduktion des Dynamikbereichs angewiesen sind. Weitere Anwendungsgebiete sind Systeme zur Schallverarbeitung und (Audio-)Datenkomprimierung, wenn Signale mit hohen Amplituden mit möglichst wenig Quantisierungsstufen erfasst werden sollen. Darüber hinaus gibt es Anwendungen im medizinischen Bereich, insbesondere als Hörhilfe bei Patienten mit Lärm-Schwerhörigkeit.

Die erfindungsgemäße Schaltkreis-Anordnung kann in digitaler oder analoger Schaltungstechnik realisiert sein.

Zumindest ein Teil der Schaltkreis-Anordnung, insbesondere die Filter, die Steuer- oder Regelungs-Funktionalität des Steuer-Schaltkreises, kann als Computerprogramm realisiert sein. Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Eine Software-Realisierung insbesondere des Steuer-Schaltkreises kann beispielsweise in "C++" erfolgen. Eine Realisierung kann auf einem beliebigen Prozessor oder DSP (digitaler Signalprozessor) erfolgen, ebenso auf einem FPGA-Baustein. Ein FPGA ("Field Programmable Gate Array") ist ein integrierter programmierbarer Schaltkreis, der in der Regel eine Vielzahl programmierbarer Zellen auf einem Chip aufweist.

Im Weiteren wird die erfindungsgemäße Signalverarbeitungs-Vorrichtung, die eine erfindungsgemäße Schaltkreis-Anordnung aufweist, näher beschrieben. Ausgestaltungen der Signalverarbeitungs-Vorrichtung gelten auch für die Schaltkreis-Anordnung und umgekehrt.

Bei der Signalverarbeitungs-Vorrichtung kann die Weiterverarbeitungs-Einheit eine Spracherkennungs-Einrichtung oder ein Hörgerät sein.

Bei einer Realisierung der Weiterverarbeitungs-Einheit als Hörgerät kommt insbesondere eine Anwendung in Frage, bei der eine Dynamikkompression zum Ausgleich von Störungen der Lautstärke-Wahrnehmung von Schwerhörigen durchgeführt wird. Im gestörten Gehör können die äußeren Haarzellen in Mitleidenschaft gezogen sein, wodurch die Erhöhung der Empfindlichkeit bei niedrigen Schallpegeln ausfällt. Das Gehör arbeitet dann anschaulich stets mit der für hohe Schallpegel vorgesehenen Empfindlichkeit. Dieses führt dazu, dass der nutzbare Bereich an Schallpegeln zwischen der Hörschwelle (sehr leise) und der Unannehmlichkeits-Schwelle (sehr laut) kleiner wird (Recruitment). Zum Ausgleich dieses Phänomens kann mittels der erfindungsgemäßen Schaltkreis-Anordnung der Signalverarbeitungs-Vorrichtung eine Dynamikkompression durchgeführt werden, die den großen Schallpegelbereich der akustischen Umwelt auf den wahrzunehmenden Bereich des Patienten anschaulich zusammendrückt.

Die Signalverarbeitungs-Vorrichtung kann auch den Eingang für ein Spracherkennungssystem bilden, insbesondere in pulsender neuronaler Netzwerk Architektur.

Die Signalverarbeitungs-Vorrichtung kann als analoge- oder digitale Filterbank eingerichtet sein.

Ausführungsbeispiele der Erfindung sind in den Figuren dargestellt und werden im Weiteren näher erläutert.

Es zeigen:

Figur 1            eine Schaltkreis-Anordnung gemäß einem bevorzugten Ausführungsbeispiel der Erfindung,

Figur 2            einen Resonator-Schaltkreis gemäß einem Ausführungsbeispiel der Erfindung,

Figur 3            eine Realisierung des in Figur 2 gezeigten Resonator- Schaltkreises als Wellendigitalfilter,

Figuren 4 und 5    Diagramme zum Veranschaulichen der Funktionalität der erfindungsgemäßen Schaltkreis- Anordnung,

Figur 6A           eine Schaltkreis-Anordnung gemäß einem anderen bevorzugten Ausführungsbeispiel der Erfindung,

Figur 6B           eine Realisierung der in Figur 6A gezeigten Resonator-Schaltkreise als Wellendigitalfilter,

Figur 7A           eine Schaltkreis-Anordnung gemäß einem weiteren bevorzugten Ausführungsbeispiel der Erfindung,

Figur 7B           eine Realisierung der in Figur 7A gezeigten Resonator-Schaltkreise als Wellendigitalfilter.

Gleiche oder ähnliche Komponente in unterschiedlichen Figuren sind mit gleichen Bezugsziffern versehen.

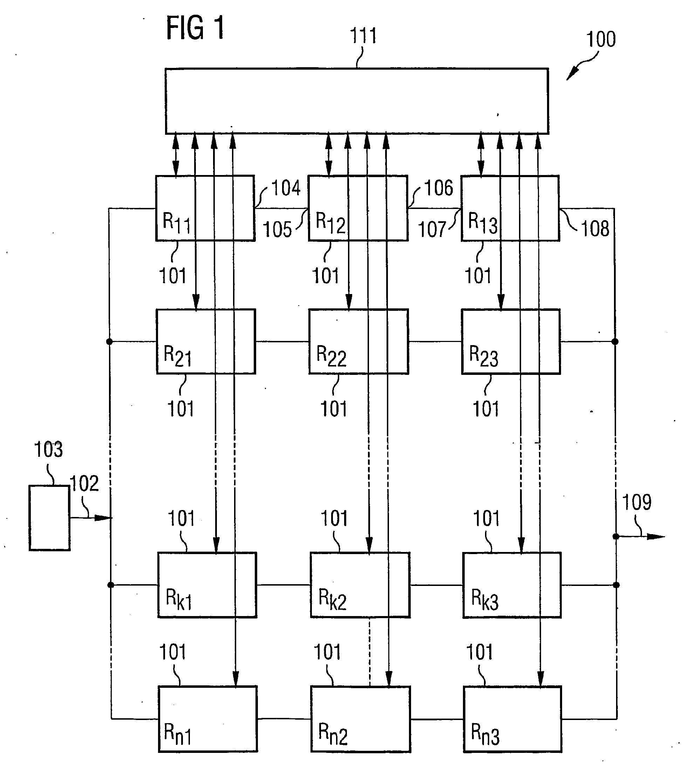

Im Weiteren wird bezugnehmend auf Fig.1 eine Schaltkreis-Anordnung 100 gemäß einem bevorzugten Ausführungsbeispiel der Erfindung beschrieben.

Die Schaltkreis-Anordnung 100 enthält eine Vielzahl von Resonator-Schaltkreisen'101, von denen jeder eine Kapazität und eine Induktivität aufweist (nicht gezeigt in Fig.1), sowie einen Eingang, an dem ein Eingabesignal bereitstellbar ist und einen Ausgang, an dem ein Ausgabesignal bereitstellbar ist. Jeweils drei der Resonator-Schaltkreise 101 sind entlang einer jeweiligen Zeile der matrixförmigen Anordnung hintereinander geschaltet, so dass ein jeweiliger Ausgang eines vorgeschalteten Resonator-Schaltkreises 101 mit einem jeweiligen Eingang eines ihm nachgeschalteten Resonator-Schaltkreises 101 gekoppelt ist. Die Werte der Induktivität und der Kapazität der Resonator-Schaltkreise 101 einer Zeile sind jeweils derart gewählt, dass die jeweilige Zeile ein Signal eines entsprechenden Frequenzintervalls in einem Umgebungsbereich der Resonanzfrequenz der Resonator-Schaltkreise 101 der Zeile transmitieren kann. Die Resonator-Schaltkreise 101 unterschiedlicher Zeilen weisen jeweils unterschiedliche Werte für L, C auf, sodass zusammengenommen die einzelnen Zeilen oder Zweige von Resonator-Schaltkreisen 101 ein zusammenhängendes Frequenzintervall abdecken, welches dem Empfindlichkeitsbereich des menschlichen Gehörs entspricht (ungefähr 20Hz bis 20kHz).

Ein Steuer-Schaltkreis 111 steht mit allen Resonator-Schaltkreisen 101 in einer Kommunikationsverbindung, d.h. der Steuer-Schaltkreis 111 ist mit allen Resonator-Schaltkreisen gekoppelt. Die Güte von jedem einzelnen der Resonator-Schaltkreise 101 ist mittels des Steuer-Schaltkreises 111 zum Steuern oder Regeln der Güte der Resonator-Schaltkreise 101 einstellbar, wobei der Steuer-Schaltkreis 111 derart eingerichtet ist, dass er die Güte der Resonator-Schaltkreise 101 abhängig von der Amplitude eines Ausgabesignals des letzten Resonator-Schaltkreises 101 einer jeweiligen Zeile einstellt. Beispielsweise wird die Güte der Resonator-Schaltkreise $R_{11}$, $R_{12}$, $R_{13}$ mittels des Steuer-Schaltkreises 111 basierend auf der Amplitude eines Signals am Ausgang des Resonator-Schaltkreises $R_{13}$ eingestellt.

In Fig.1 ist ferner eine Schallquelle 103 gezeigt, welche ein akustisches Signal als globales Eingabesignal 102 emittiert. Dieses wird den Eingängen der Resonator-Schaltkreise 101 ($R_{11}$, $R_{21,}$ ..., $R_{k1}$, ..., $R_{n1}$) der ersten Spalte von Resonator-Schaltkreisen 101 bereitgestellt.

Im Weiteren wird der in der ersten Zeile und der ersten Spalte von Resonator-Schaltkreisen angeordnete Resonator-Schaltkreis 101 $R_{11}$ betrachtet. Diesem wird an einem Eingang das globale Eingabesignal 102 der Schallquelle 103 bereitgestellt. Der Resonator-Schaltkreis 101 $R_{11}$ lässt eine von den ihm zugeordneten Werten L und C abhängige Frequenzkomponente des globalen Eingabesignals 102 hindurch, welche an einem Ausgang des Resonator-Schaltkreises $R_{11}$ als erstes lokales Ausgabesignal 104 bereitgestellt ist. Ferner wird aufgrund der Funktionalität des Resonator-Schaltkreises 101 $R_{11}$ abhängig von seiner (gegenwärtigen) Güte Q das globale Eingabesignal 102 in seiner Amplitude verändert. Die Güte Q des Resonator-Schaltkreises 101 $R_{11}$ wird mittels eines ohmschen Widerstands (nicht gezeigt in Fig.1) des Resonator-Schaltkreises 101 $R_{11}$ geregelt, wobei der Steuer-Schaltkreis 111 diesem regelbaren ohmschen Widerstand ein entsprechendes Steuersignal bereitstellt, wodurch der Widerstand auf einen vorbestimmten Wert eingestellt wird. Dadurch wird die Güte des Resonator-Schaltkreises 101 eingestellt, so dass in einem nachfolgenden Verarbeitungs-Zyklus gemäß diesem Wert der Güte ein Eingabesignal stärker oder schwächer gedämpft wird. Da die Schaltkreis-Anordnung 100 zur Dynamikkompression des globalen Eingabesignals 102 eingerichtet ist, werden anschaulich Signalbereiche hoher Amplitude stärker geschwächt als Signalbereiche geringer Amplitude.

Das erste lokale Ausgabesignal 104 wird dem dem Resonator-Schaltkreis 101 $R_{11}$ nachgeschalteten Resonator-Schaltkreis 101 $R_{12}$ als erstes lokales Eingabesignal 105 bereitgestellt. Das erste lokale Eingabesignal 105 durchläuft den Resonator-Schaltkreis 101 $R_{12}$, wobei an einem Ausgang das zweite lokale Ausgabesignal 106 bereitgestellt wird. Das zweite lokale Ausgabesignal 106 dient als zweites lokales Eingabesignal 107 des dem Resonator-Schaltkreis 101 $R_{12}$ nachgeschalteten Resonator-Schaltkreises 101 $R_{13}$. An dessen Ausgang 108 ist ein drittes lokales Ausgabesignal 108 bereitgestellt. Dieses wird gemeinsam mit den jeweils auf ein separates Frequenzintervall bezogenen Ausgabesignalen der jeweils letzten in einer Zeile angeordneten Resonator-Schaltkreisen 101 ($R_{13}$, $R_{23}$, ..., $R_{k3}$, ..., $R_{n3}$) zu einem globalen Ausgabesignal 109 zusammengesetzt (addiert).

Bei jedem der Resonator-Schaltkreise 101 einer jeweiligen Zeile von Resonator-Schaltkreisen ($R_{k1}$, $R_{k2}$, $R_{k3}$) wird die Güte aller Resonator-Schaltkreise 101 der Zeile basierend auf der Amplitude des Ausgabesignals an dem Ausgang des jeweils letzten Resonator-Schaltkreises (in der k-ten Zeile Resonator-Schaltkreis $R_{k3}$) mittels des Steuer-Schaltkreises 111 geregelt.

Das zusammengesetzte globale Ausgabesignal 109 ist somit gegenüber dem globalen Eingabesignal 102 einer Dynamikkompression unterzogen.

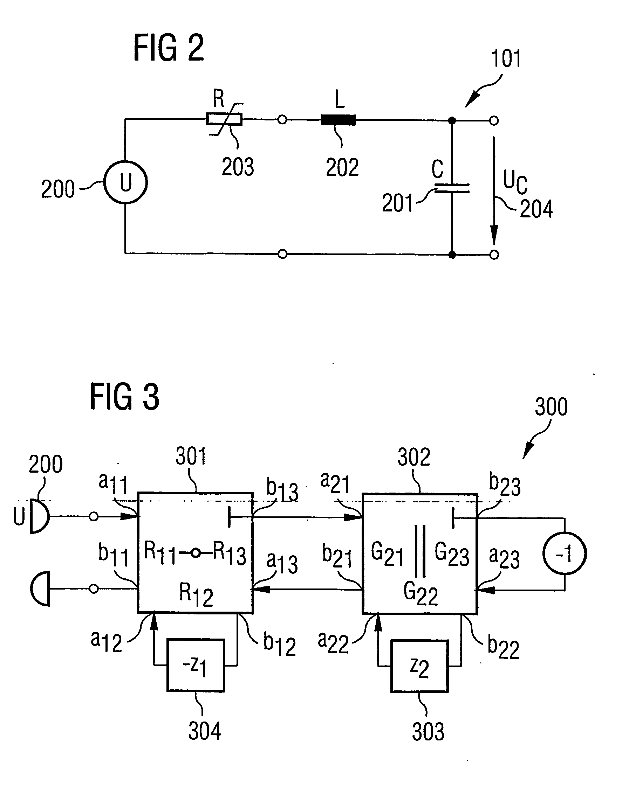

Im Weiteren wird bezugnehmend auf Fig.2 der Resonator-Schaltkreis 101 aus Fig.1 beschrieben.

In Fig.2 ist ein Eingabesignal 200 als Spannungsquelle U symbolisiert. Ferner ist ein Ausgabesignal 204 als Spannung $U_c$ symbolisiert. Das Eingabesignal 200 ist zwischen einem ersten Anschluss eines ohmschen Widerstands 203 und einem ersten Anschluss einer Kapazität 201 bereitgestellt. Das Ausgabesignal 204 ist zwischen dem ersten Anschluss der Kapazität 201 und einem zweiten Anschluss der Kapazität 201 bereitgestellt. Ferner ist ein zweiter Anschluss des regelbaren ohmschen Widerstands 203 mit einem ersten Anschluss einer Induktivität 202 gekoppelt, und ein zweiter Anschluss der Induktivität 202 ist mit dem zweiten Anschluss der Kapazität 201 gekoppelt.

Der Wert des ohmschen Widerstands R 203 ist mittels des Steuer-Schaltkreises 111 einstellbar. Der Resonator-Schaltkreis 101 aus Fig.2 stellt somit anschaulich einen Filter mit regelbarer Dämpfung dar.

Bei der erfindungsgemäßen Schaltkreis-Anordnung 100 sind in jeder Zeile drei (oder allgemein N) Resonator-Schaltkreise 101 als Filterelemente rückkopplungsfrei hintereinander geschaltet. Das zeitabhängige Ausgabesignal $U_c$(t), wobei t die Zeit ist, eines vorgeschalteten Filters definiert jeweils das Eingabesignal U 200 des dem vorgeschalteten Filter nachgeschalteten Filters.

Der Widerstand R 203 kann in nichtlinearer Abhängigkeit von der Ausgangsspannung $U_c$(t) verändert werden (Regelung), in Abhängigkeit von $U_c$(t) des jeweils vorangeschalteten Filters (Steuerung), oder auch in für alle Filter gleichzeitig in Abhängigkeit von $U_c$(t) der letzten Filterstufe einer Reihe.

Im Weiteren wird beschrieben, auf Basis welcher Rechenvorschrift gemäß dem beschriebenen Ausführungsbeispiel der Wert R eines jeweiligen ohmschen Widerstands R 203 eingestellt wird.

Hierfür wird zunächst eine einzustellende Güte Q berechnet.

Gemäß dem beschriebenen Ausführungsbeispiel wird die Güte Q des Filters gemäß einer Boltzmann-Funktion gedämpft:

$$Q(t) = (Q_0 - Q_{min})(1 - [\frac{2}{1 + \exp\{-SAT\,|\,U_c(t)\,|\}} - 1]) + Q_{min} \qquad (1)$$

In Gleichung (1) ist Q(t) die Abhängigkeit der Güte Q von der Zeit t. $Q_0$ ist eine vorgebbare Maximalgüte des Resonator-Schaltkreises 101 (z.B. $Q_0$=10). $Q_{min}$ ist eine vorgebbare minimale Güte des Resonator-Schaltkreises (z.B. $Q_{min}$=1). SAT ist eine vorgebbare Sättigungsschwelle, das heißt ein Parameter, mit dem anschaulich die Zeitabhängigkeit der Güte eingestellt werden kann (z.B. SAT=1).

Die Boltzmann-Funktion (1) nähert die Empfindlichkeitskurve der äußeren Haarsinneszellen im Innenohr an. Die Funktion kann bei Bedarf durch eine Boltzmann-Funktion zweiter Ordnung ersetzt werden, die unter Einführung eines weiteren Parameters eine noch genauere Anpassung ermöglicht. In Gleichung (1) ist eine einfache Boltzmann-Funktion erster Ordnung verwendet, da sie nur einen freien Parameter (nämlich SAT) aufweist und somit mit geringem numerischen Aufwand verarbeitet werden kann.

Aus der Güte Q des Filters berechnet sich der einzustellende Wert des nichtlinearen Widerstands R zu:

$$R(t) = \sqrt{L/C}\, Q(t) \qquad (2)$$

Somit hängt der zeitabhängige Wert des ohmschen Widerstands R(t) von dem Wert der Induktivität L und der Kapazität C sowie der zeitabhängigen Güte Q(t) ab.

Anschaulich bilden Gleichungen (1) und (2) die Regelungsvorschrift für das Einstellen des Werts R des ohmschen Widerstands 203 mittels des Steuer-Schaltkreises 111.

Der von dem in Fig.2 gezeigten Resonator-Schaltkreis 101 gebildete Filter ist bei sehr geringen Amplituden $U_c(t)$ linear (mit $Q \rightarrow Q_0$ für $U_c(t) \rightarrow 0$). Ebenso ist er bei sehr großen Amplituden $U_c(t)$ näherungsweise linear ($Q \rightarrow Q_{min}$ für $U_c(t) \rightarrow \infty$). Die Dynamikkompression K erfolgt im Bereich der Sättigungsschwelle (SAT) und beträgt $K = Q_0/Q_{min}$. Im Falle von N=4 hintereinander geschalteten Filterstufen (in Fig.1 sind allerdings nur drei Filterstufen mittels dreier Resonator-Schaltkreise in einer Zeile vorgesehen) und den Werten $Q_0 = 10$ und $Q_{min} = 1$ ist eine starke Kompression um 80dB ($K_N = (Q_0/Q_{min})^N$) realisierbar.

Um den gesamten Hörbereich des Menschen abzudecken, wird eine Filterbank mit Resonanzfrequenzen im Bereich von ungefähr 20Hz bis ungefähr 20kHz realisiert, was durch typischerweise fünfzig bis hundert Zeilen von Resonator-Schaltkreisen 101 (d.h. n=50 bis n=100) realisiert wird. Gemäß dem beschriebenen Ausführungsbeispiel wird der Wert der Induktivität auf L=1H festgelegt. Der jeweilige Wert C wird dann für jede Zeile von Resonator-Schaltkreisen 101 gemäß der von dieser Zeile abgedeckten Filterfrequenz $f_0$ aus der Resonanzfrequenz des entsprechenden LC-Glieds berechnet:

$$C = (4\pi^2 f^2 L)^{-1} \qquad (3)$$

Es ist anzumerken, dass die nichtlineare Güte Q für jede Filterfrequenz $f_0$, d.h. für jede Zeile von Resonator-Schaltkreisen 101, unabhängig berechnet wird. Bezugnehmend auf Fig.1 bedeutet dies, dass jeder Zeile von Oszillator-Schaltkreisen 101 eine entsprechende Filterfrequenz $f_0$ zugeordnet ist, für welche der Wert der Güte Q(t) berechnet wird.

Im Weiteren wird bezugnehmend auf Fig.3 ein Wellendigitalfilter 300 als Realisierung der in Fig.2 gezeigten Resonatorstufe 101 beschrieben.

Ein Wellendigitalfilter stellt eine Klasse von Digitalfiltern mit besonders günstigen Eigenschaften dar. Sie sind traditionellen Filtern aus den klassischen Bauelementen der Nachrichtentechnik nachgebildet und werden mit Hilfe moderner integrierter Digitalschaltungen betrieben. Gemäß der Technologie eines Wellendigitalfilters kann anschaulich ein analoges Modell digital realisiert werden (beispielsweise unter Verwendung eines Computers).

Im Weiteren werden anschaulich die Komponenten des Wellendigitalfilters 300 aus Fig.3 den Komponenten des Resonator-Schaltkreises 101 aus Fig.2 anschaulich zugeordnet und die entsprechenden Größen definiert.

Ein erster Block 301 des Wellendigitalfilters 300 enthält einen reflexionsfreien seriellen Koppler mit den Impedanzen R11 und R13. Anschaulich repräsentiert R11 den regelbaren ohmschen Widerstand R 203, bezogen auf einen Referenzwiderstand. R12 repräsentiert einen korrigierten Widerstand (Impedanz) der Spule L 202 bezogen auf eine Basisfrequenz. Ein zweiter Block 302 enthält einen parallelen Koppler, der die parallele Verschaltung der Kapazität 201 wiedergibt, wobei in dem zweiten Block die Leitwerte G21, G22, G23 dargestellt sind. G21 ist ein Eingangs-Leitwert des zweiten Blocks (G12=1/R13) 302, G23 ist ein Ausgangs-Leitwert des zweiten Blocks 302. Mittels des Leitwerts G22 wird der Widerstand der Kapazität C 201 modelliert. Ein dritter Block 303 repräsentiert einen Speicher bzw. ein Filterregister für die Kapazität 201 und ein vierter Block 304 repräsentiert einen Speicher bzw. ein Filterregister für die Spule 202.

Im Weiteren werden die in Fig.3 gezeigten Variablen definiert. Es ergeben sich die Widerstände und Leitwerte für jede Filterfrequenz zu:

$$R11 = R/R\_B \qquad (4)$$

$$R12 = 2\pi\ F\_B\ L/(R\_B\ \tan[\pi\ F\_B/f\_s]) \qquad (5)$$

$$R13=R11+R12 \qquad (6)$$

$$G21=R13^{-1} \qquad (7)$$

$$G22=2\pi \ F\_B \ C \ R\_B/\tan(\pi \ F\_B/f\_s) \qquad (8)$$

$$G23=G21+G22 \qquad (9)$$

Hierbei ist R der ohmsche Widerstand 203 und R_B ein vorgebbarer Bezugswiderstand. F_B ist eine vorgebbare Bezugsfrequenz. Die Werte R_B und F_B dienen zum Skalieren. Da die Realisation gemäß dem beschriebenen Ausführungsbeispiel mit Double Precision Float-Variablen realisiert ist, ist diese Normierung nicht relevant, wohl aber, wenn Integer-Arithmetik verwendet wird. L ist die Induktivität der Spule 202. Der Wert f_s ist eine Sampling-Frequenz des abgetasteten Zeitsignals. Die Größen R11, R12, R13 sind ohmsche Widerstände, wohingegen die Größen G21, G22 und G23 Leitwerte, das heißt inverse ohmsche Widerstände sind.

Filter-Koeffizienten g1, g2 ergeben sich zu:

$$g1=R11/R13 \qquad (10)$$

$$g2=G21/G23 \qquad (11)$$

Die Anfangswerte der Filterregister Z1 (vierter Block 304) und Z2 (dritter Block 303) werden zu Null initialisiert.

Die Signale an den einzelnen Ports lassen sich sukzessive berechnen. Für die "Vorwärtswelle" des Signals, das heißt anschaulich die Koeffizienten an den gemäß Fig.3 nach rechts orientierten Pfeile, ergibt sich:

$$b13=-(U+Z1) \qquad (12)$$

$$b20=-g2(Z2-b13) \qquad (13)$$

$$b23=b20+Z2 \qquad (14)$$

Die Größe U in Gleichung (12) ist das Eingabesignal 200.

Für die "Rückwärtswelle", das heißt anschaulich die gemäß Fig.3 nach links orientierten Pfeile, ergeben sich die Koeffizienten:

$$b22=b20+b23 \qquad (15)$$

$$b21=b22+Z2-b13 \qquad (16)$$

$$a0=b21-b13 \qquad (17)$$

$$b11=U-g1 \; a0 \qquad (18)$$

$$b12=-(b11+b21) \qquad (19)$$

Das Ausgabesignal $U_c$ 204 berechnet sich dann zu:

$$U_c=(b22+Z2[sec])/2 \qquad (20)$$

Die Filterregister (Blöcke 303, 304) werden wie folgt aktualisiert:

$$Z1=-b12 \qquad (21)$$

$$Z2=b22 \qquad (22)$$

Das Ausgabesignal $U_c$ 204 wird als Eingabesignal U 200 an die der betrachteten Filterstufe 101 nachgeschaltete Filterstufe 101 übergeben. Basierend auf dem Ausgabesignal $U_c$ 204 der letzten Filterstufe 101 einer Zeile von Filterstufen 101 wird die einzustellende Güte der hintereinander geschalteten Filter 101 gemäß Gleichung (1) neu ermittelt. Aus dem so ermittelten Wert für die Güte Q wird der Wert des die Dämpfung bestimmenden Widerstands R gemäß Gleichung (2) berechnet. Mit dem veränderten Wert des ohmschen Widerstands R 203 werden die Filterwiderstände (R11, R12, R13, G21, G22, G23) und Filterkoeffizienten (gl, g2) gemäß Gleichungen (4) bis (11) neu berechnet. Nach diesem Schritt wird das Ausgabesignal für eine nächste Zeitscheibe berechnet. Mit anderen Worten kann das Zeitspektrum in mehrere Zeitscheiben zergliedert werden, die sukzessive numerisch berechnet werden.

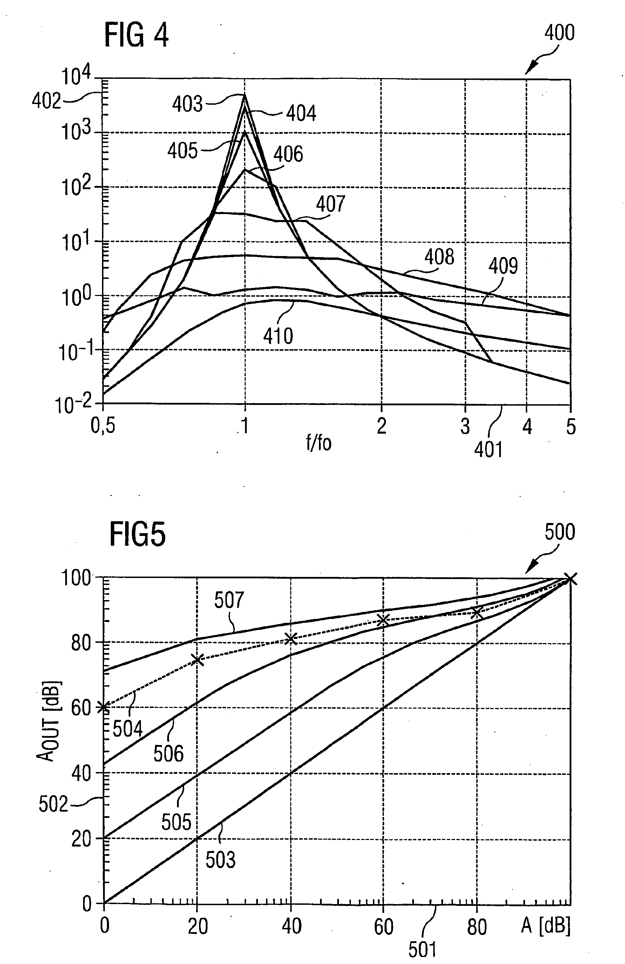

Im Weiteren wird bezugnehmend auf Fig.4 ein Diagramm 400 erläutert, in dem die Funktionalität der erfindungsgemäßen Schaltkreis-Anordnung gemäß einem bevorzugten Ausführungsbeispiel der Erfindung gezeigt ist. Diagramm 400 bezieht sich auf eine Schaltkreis-Anordnung mit N=4 hintereinander geschalteten Resonator-Schaltkreisen. Als maximaler Q-Wert ist $Q_0=10$ angenommen, als minimaler Q-Wert ist $Q_{min}=1$ angenommen.

Entlang einer Abszisse 401 des Diagramms 400 ist in einer logarithmischen Darstellung die auf eine Referenzfrequenz $f_0$ normierte Frequenz eines Signals aufgetragen. Entlang einer Ordinate 402 ist in einer logarithmischen Darstellung die Reaktion des Systems auf ein Eingabesignal einer bestimmten Intensität gezeigt. Erste bis achte Kurven 403 bis 410 stellen die Frequenzgang (d.h. hier den jeweiligen Wert der Maximalamplitude des Filterausgangs) der erfindungsgemäßen Schaltkreis-Anordnung für unterschiedliche Signal-Amplituden (bezogen auf eine Referenzamplitude) dar. Die erste Kurve 403 entspricht einer Amplitude von $1 \times 10^{-9}$, die zweite Kurve 404 entspricht einer Amplitude von $1 \times 10^{-4}$, die dritte Kurve 405 entspricht einer Amplitude von $1 \times 10^{-3}$, die vierte Kurve 406 entspricht einer Amplitude von $1 \times 10^{-2}$, die fünfte Kurve 407 entspricht einer Amplitude von $1 \times 10^{-1}$, die sechste Kurve 408 entspricht einer Amplitude von $1 \times 10^{0}$, die siebte Kurve 409 entspricht einer Amplitude von $1 \times 10^{1}$ und die achte Kurve 410 entspricht einer Amplitude von $1 \times 10^{6}$. Ferner ist als Eingabesignal eine Sinusschwingung angenommen, die mit einem $cos^2$-Fenster gefenstert ist. Kurven 403 bis 410 ergeben sich für eine gesamte Filterbank aus N=4 rückkopplungsfrei hintereinander geschalteten Resonator-Schaltkreisen.

Zunächst ist aus dem Diagramm 400 ersichtlich, dass die Dämpfung des Eingabesignals umso stärker ist, je höher die Signalintensität bzw. Signalamplitude ist. Bei sehr kleinen Amplituden sind die Filter linear und die Resonanzüberhöhung beträgt ungefähr 80dB. Die Antwort der Filterbank nimmt zu hohen tiefen Frequenzen sehr steil ab, da die Filter als Tiefpass realisiert sind (vgl. Fig. 2). Die hochfrequente Antwort der Filter fällt mit ungefähr 6dB pro Oktave ab, bedingt durch die Skalierung der Filterparameter mit $f_0$. Die Kurven in Fig.4 bilden die stark asymmetrische Frequenz-Selektivität des menschlichen Gehörs in guter Näherung nach.

Im Weiteren wird bezugnehmend auf Fig.5 die Beziehung zwischen Amplituden des Eingabesignals und des Ausgabesignals einer erfindungsgemäßen Schaltkreis-Anordnung beschrieben.

In dem Diagramm 500 ist entlang einer Abszisse in logarithmischer Darstellung ein Schalldruckpegel $A_{in}$ in dB aufgetragen, bezogen auf einen Schalldruck der Bezugsgröße 20μPa. Entlang einer Ordinate 502 ist in willkürlichen Einheiten die Stärke eines Ausgabesignals $A_{OUT}$ in dB aufgetragen. Kurven 503 bis 507 zeigen für unterschiedliche Szenarien die Wachstumsfunktion einer Filterkaskade aus vier Resonator-Schaltkreisen (Hintereinanderschaltung von N=4 Filtern) bei der Resonanzfrequenz $f_0$. Als minimale Güte ist $Q_{min}$=1 angenommen.

Eine erste Kurve 503 zeigt eine lineare Wachstumsfunktion. Eine zweite Kurve 504 zeigt eine Wachstumsfunktion des Innenohrs, d.h. die Geschwindigkeit der Basilarmembran bezogen auf den Schalldruck gemessen vor dem Trommelfell. Die Daten der zweiten Kurve 504 sind aus [2] entnommen. Eine dritte Kurve 505 zeigt den Kurvenverlauf für eine Güte Q=2, eine vierte Kurve 506 zeigt den Verlauf für Q=4 und eine fünfte Kurve 507 zeigt den Verlauf für Q=10.

Anschaulich ist in Fig.5 somit die Wachstumsfunktion eines Filterausgangs für $f=f_0$ mit der Filtergüte Q als Parameter gezeigt. Bei sehr großen und sehr kleinen Amplituden sind die Wachstumsfunktionen näherungsweise linear. Auffällig ist der große Kompressionsbereich (insbesondere bei großem Q), der sich über mehr als vier Dekaden erstreckt. Der große Dynamikbereich des Eingabesignals (100dB) wird auf 40dB (für Q=10) komprimiert. Aufgrund der Resonanzüberhöhung werden leise Signale frequenzspezifisch "verstärkt". Die Wachstumsfunktion bildet am lebenden Hörsystem gemessene Schwingungsantworten sehr gut nach (vgl. mit Kurve 504). Daher ist mit der erfindungsgemäßen Schaltkreis-Anordnung eine näherungsweise technische Nachbildung der nichtlinearen Vorverarbeitung im Innenohr realisiert.

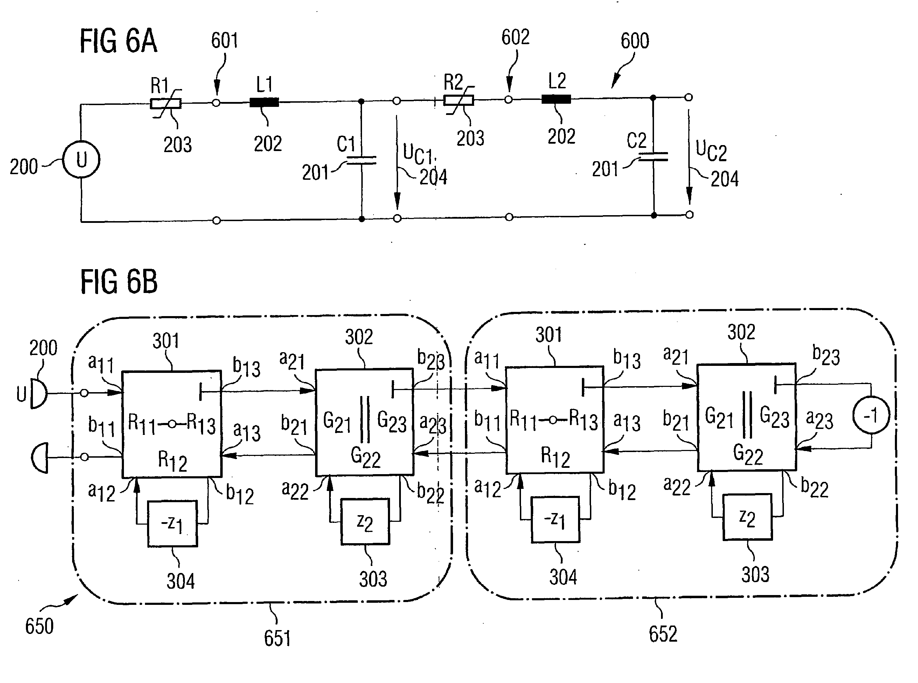

Im Weiteren wird bezugnehmend auf Fig.6A eine Schaltkreis-Anordnung 600 gemäß einem anderen bevorzugten Ausführungsbeispiel der Erfindung beschrieben.

Die Schaltkreis-Anordnung 600 ist gebildet aus einem ersten Resonator-Schaltkreis 601 und einem zweiten Resonator-Schaltkreis 602, von denen jeder aufgebaut ist wie der in Fig.2 gezeigte Resonator-Schaltkreis 101. Der zweite Resonator-Schaltkreis 602 ist dem ersten Resonator-Schaltkreis 601 nachgeschaltet.

Anschaulich kann die Schaltkreis-Anordnung 600 als direkt gekoppelte Realisierung von zwei (N=2) hintereinander geschalteten Resonator-Schaltkreisen 601, 602 angesehen werden.

Wie in Fig. 6A gezeigt ist der zweite Anschluss der Spule 202 des vorgeschalteten Resonator-Schaltkreises 601 mit dem ersten Anschluss des ohmschen Widerstandes 203 des nachgeschalteten zweiten Resonator-Schaltkreises 602 gekoppelt.

Gemäß dem in Fig. 6A gezeigten Ausführungsbeispiel miteinander unmittelbar verkoppelter Resonator-Schaltkreise 601, 602 ist die Ausgabespannung $U_{C1}$ des vorgeschalteten Resonator-Schaltkreises 601 gleich der Eingabespannung des folgenden Resonator-Schaltkreises 602. Ferner ist der Ausgabestrom des ersten Resonator-Schaltkreises 601 gleich dem Eingabestrom des zweiten Resonator-Schaltkreises 602.

Es ist anzumerken, dass die Werte der Widerstände R1 bzw. R2, der Induktivitäten L1 bzw. L2 sowie der Kapazitäten C1 bzw. C2 der Resonator-Schaltkreise 601, 602 voneinander unterschiedlich sein können bzw. unterschiedlich eingestellt/geregelt werden können.

Im Weiteren wird bezugnehmend auf Fig.6B eine Realisierung der in Fig.6A gezeigten Resonator-Schaltkreise 601, 602 als Wellendigitalfilter 650 beschrieben.

Anschaulich ist das Wellendigitalfilter 650 gebildet aus einer ersten Komponente 651, welche den ersten Resonator-Schaltkreis 601 repräsentiert, und aus einer zweiten Komponente 652, welche den zweiten Resonator-Schaltkreis 602 repräsentiert. Entsprechend der verkoppelten Konfiguration der Resonator-Schaltkreise 601, 602 gemäß Fig. 6A sind die beiden Komponenten 651, 652 in der Fig.6B gezeigten Weise direkt miteinander gekoppelt. Der interne Aufbau jeder der Komponenten 651, 652 entspricht im Wesentlichen jener des Wellendigitalfilters 300 aus Fig.3.

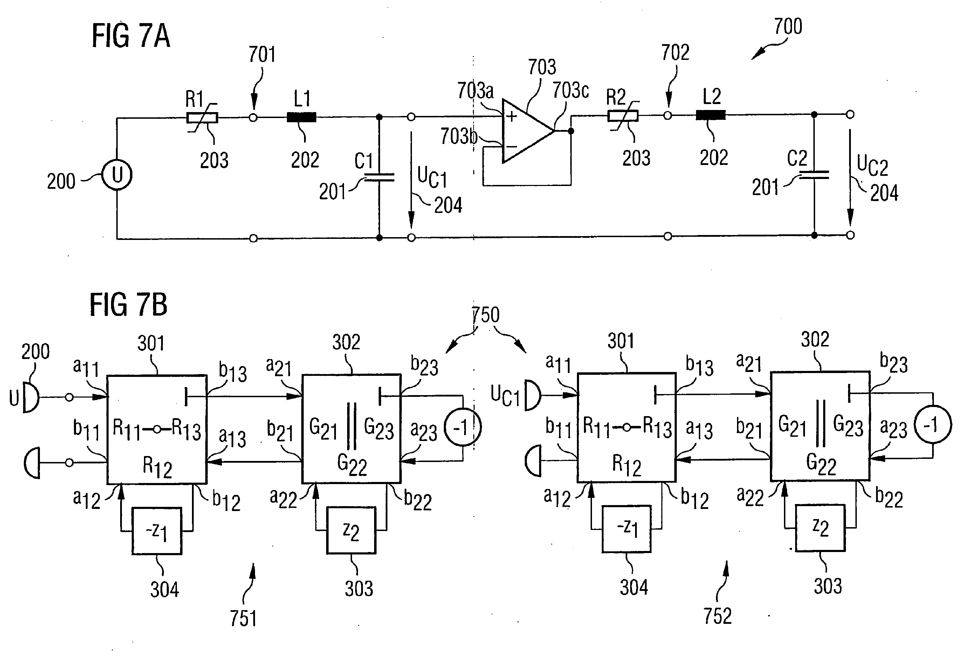

Im Weiteren wird bezugnehmend auf Fig.7A eine Schaltkreis-Anordnung 700 gemäß noch einem anderen Ausführungsbeispiel der Erfindung beschrieben.

Die Schaltkreis-Anordnung 700 ist gebildet aus einem ersten Resonator-Schaltkreis 701 und einem zweiten Resonator-Schaltkreis 702, welche in Serie geschaltet sind. Anschaulich sind die Resonator-Schaltkreise 701, 702 in einer voneinander entkoppelten Konfiguration hintereinander geschaltet, d.h., dass zwischen die Resonator-Schaltkreise 701 und 702 ein Zwischenelement geschaltet ist.

Jeder der Resonator-Schaltkreise 701, 702 ist im Wesentlichen aufgebaut wie der in Fig.2 gezeigte Resonator-Schaltkreis 101. Ferner ist zwischen dem ersten Resonator-Schaltkreis 701 und dem zweiten Resonator-Schaltkreis 702 ein Operationsverstärker 703 vorgesehen, wobei ein nichtinvertierender Eingang 703a des Operationsverstärkers 703 mit dem zweiten Anschluss der Spule 202 des vorgeschalteten ersten Resonator-Schaltkreises 701 gekoppelt ist. Ferner ist ein invertierender Eingang 703b des Operationsverstärkers 703 mit dessen Ausgang 703c rückgekoppelt und mit dem ersten Anschluss des ohmschen Widerstands 203 des dem ersten Resonator-Schaltkreis 701 nachgeschalteten zweiten Resonator-Schaltkreises 702 gekoppelt.

Gemäß dieser Konfiguration ist die Ausgabespannung des vorgeschalteten Resonator-Schaltkreises 701 $U_{C1}$ 204 gleich der Eingabespannung des dem ersten Resonator-Schaltkreis 701 nachgeschalteten zweiten Resonator-Schaltkreises 702. Der Ausgabestrom eines jeweiligen Resonator-Schaltkreises ist Null. Der Eingabestrom des dem vorgeschalteten ersten Resonator-Schaltkreis 701 nachgeschalteten zweiten Resonator-Schaltkreises 702 beruht lediglich auf der Impedanz des nachgeschalteten zweiten Resonator-Schaltkreises 702. Wie in Fig.7A gezeigt, ist in Analogtechnik eine Realisation dieser Umstände mittels eines Impedanzwandlers realisierbar, der die Ausgabespannung des vorgeschalteten Resonator-Schaltkreises 701 dem Eingang des nachgeschalteten Resonator-Schaltkreises 702 einprägt.

Im Weiteren wird bezugnehmend auf **Fig.7B** ein Wellendigitalfilter 750 als Realisierung der Schaltkreis-Anordnung 700 aus Fig.7A beschrieben.

Das Wellendigitalfilter 750 ist in eine erste Komponente 751 und in eine zweite Komponente 752 aufgeteilt, wobei die erste Komponente 751 den ersten Resonator-Schaltkreis 701 repräsentiert, und wobei die zweite Komponente 752 den zweiten Resonator-Schaltkreis 702 repräsentiert. Aufgrund der Funktionalität des Operationsverstärkers 703 sind die beiden Komponenten 751, 752 voneinander anschaulich gekoppelt. Der interne Aufbau jeder der Komponenten 751, 752 entspricht im Wesentlichen der in Fig.3 gezeigten Konfiguration. Das Eingabesignal der ersten Komponente 751 ist U, das Eingabesignal der zweiten Komponente 752 ist $U_{C1}$.

In diesem Dokument sind folgende Veröffentlichungen zitiert:

[1] Schukat-Talamazzini, EG (1995) "Automatische Spracherkennung", Friedrich Vieweg & Sohn Verlagsgesellschaft, Braunschweig/Wiesbaden, ISBN 3-528-05492-1, Kapitel 1 bis 3

[2] Ruggero, MA et al. (2000) "Mechanical bases of frequency tuning and neural excitation at the base of the cochlea: comparison of basilar-membrane vibrations and auditory nerve-fiber responses in chinchilla", Proc.Natl.Acad. Sci. USA 97(22):11744-11750

[3] US 3,808,540

[4] DE 24 01 816 C2

Bezugszeichenliste

| | |
|---|---|
| 100 | Schaltkreis-Anordnung |
| 101 | Resonator-Schaltkreise |
| 102 | globales Eingabesignal |
| 103 | (Schall-)Signalquelle |
| 104 | erstes lokales Ausgabesignal |
| 105 | erstes lokales Eingabesignal |
| 106 | zweites lokales Ausgabesignal |
| 107 | zweites lokales Eingabesignal |
| 108 | drittes lokales Ausgabesignal |
| 109 | globales Ausgabesignal |
| 111 | Steuer-Schaltkreis |
| 200 | Eingabesignal |
| 201 | Kapazität |
| 202 | Induktivität |
| 203 | regelbarer ohmscher Widerstand |
| 204 | Ausgabesignal |
| 300 | Wellendigitalfilter |
| 301 | erster Block (serieller Koppler) |
| 302 | zweiter Block (paralleler Koppler) |
| 303 | dritter Block (Speicherelement für Kapazität) |
| 304 | vierter Block (Speicherelement für Induktivität) |
| 400 | Diagramm |
| 401 | Abszisse |

| | |
|---|---|
| 402 | Ordinate |
| 403 | erste Kurve |
| 404 | zweite Kurve |
| 405 | dritte Kurve |
| 406 | vierte Kurve |
| 407 | fünfte Kurve |
| 408 | sechste Kurve |
| 409 | siebte Kurve |
| 410 | achte Kurve |
| 500 | Diagramm |
| 501 | Abszisse |
| 502 | Ordinate |
| 503 | erste Kurve |
| 504 | zweite Kurve |
| 505 | dritte Kurve |
| 506 | vierte Kurve |
| 507 | fünfte Kurve |
| 600 | Schaltkreis-Anordnung |
| 601 | erster Resonator-Schaltkreis |
| 602 | zweiter Resonator-Schaltkreis |
| 650 | Wellendigitalfilter |
| 651 | erste Komponente |
| 652 | zweite Komponente |
| 700 | Schaltkreis-Anordnung |
| 701 | erster Resonator-Schaltkreis |
| 702 | zweiter Resonator-Schaltkreis |
| 703 | Operationsverstärker |
| 703a | nichtinvertierender Eingang |
| 703b | invertierender Eingang |
| 703c | Ausgang |
| 750 | Wellendigitalfilter |
| 751 | erste Komponente |
| 752 | zweite Komponente |

**Patentansprüche**

1.  Schaltkreis-Anordnung,

    - mit einer Mehrzahl von in Serie geschalteten Resonator-Schaltkreisen, wobei ein Ausgabesignal eines jeweils vorgeschalteten Resonator-Schaltkreises dem jeweils nachgeschalteten Resonator-Schaltkreis als Eingabesignal bereitstellbar ist, wobei jeder Resonator-Schaltkreis zum Generieren eines Ausgabesignals aus einem Eingabesignal eingerichtet ist und aufweist:

    -- eine Kapazität und eine Induktivität,
    -- einen Eingang, an dem das Eingabesignal bereitstellbar ist,
    -- einen Ausgang, an dem das Ausgabesignal bereitstellbar ist;

    - mit einem Steuer-Schaltkreis zum Steuern oder Regeln der Güte der Resonator-Schaltkreise, wobei der Steuer-Schaltkreis derart eingerichtet ist, dass er die Güte der Resonator-Schaltkreise abhängig von dem Signalverlauf der Signalamplitude des Eingabesignals und/oder des Ausgabesignals steuert oder regelt.

2.  Schaltkreis-Anordnung nach Anspruch 1,
    bei welcher die Resonator-Schaltkreise einen mittels des Steuer-Schalkreises steuerbaren ohmschen Widerstand aufweisen.

3.  Schaltkreis-Anordnung nach Anspruch 2,
    bei der

- das Eingabesignal zwischen einem ersten Anschluss des ohmschen Widerstands und einem ersten Anschluss der Kapazität bereitstellbar ist;
- das Ausgabesignal zwischen dem ersten Anschluss der Kapazität und einem zweiten Anschluss der Kapazität bereitstellbar ist;
- ein zweiter Anschluss des ohmschen Widerstands mit einem ersten Anschluss der Induktivität und ein zweiter Anschluss der Induktivität mit dem zweiten Anschluss der Kapazität gekoppelt ist.

4. Schaltkreis-Anordnung nach einem der Ansprüche 1 bis 3, bei welcher der Steuer-Schaltkreis derart eingerichtet ist, dass er die Güte der Resonator-Schaltkreise basierend auf einer Boltzmann-Funktion und/oder deren Ableitung steuert, wobei die Boltzmann-Funktion die Amplitude des Ausgabesignals als Parameter enthält.

5. Schaltkreis-Anordnung nach einem der Ansprüche 1 bis 4, bei welcher der Steuer-Schaltkreis derart eingerichtet ist, dass er die Güte der Resonator-Schaltkreise in Abhängigkeit von der Amplitude des Ausgabesignals basierend auf einer für ein Ohr eines Menschen ermittelten Empfindlichkeitscharakteristik einstellt.

6. Schaltkreis-Anordnung nach einem der Ansprüche 1 bis 5, bei welcher der Steuer-Schaltkreis derart eingerichtet ist, dass er die Güte der Resonator-Schaltkreise umso geringer einstellt, je höher die Amplitude des Ausgabesignals ist.

7. Schaltkreis-Anordnung nach Anspruch 6, bei welcher der Steuer-Schaltkreis derart eingerichtet ist, dass er die Güte der Resonator-Schaltkreise in einer nichtlinearen Abhängigkeit von der Amplitude des Ausgabesignals einstellt.

8. Schaltkreis-Anordnung nach einem der Ansprüche 1 bis 7, bei welcher der Steuer-Schaltkreis derart eingerichtet ist, dass er die Güte der Resonator-Schaltkreise derart einstellt, dass die Amplitude des Ausgabesignals innerhalb eines vorbestimmten Intervalls ist.

9. Schaltkreis-Anordnung nach einem der Ansprüche 1 bis 8, bei welcher der zweite Anschluss der Spule eines vorgeschalteten Resonator-Schaltkreises mit dem ersten Anschluss des ohmschen Widerstands des dem vorgeschalteten Resonator-Schaltkreis nachgeschalteten Resonator-Schaltkreises gekoppelt ist.

10. Schaltkreis-Anordnung nach einem der Ansprüche 1 bis 8, mit einem Operationsverstärker zwischen einem vorgeschalteten Resonator-Schaltkreis und dem ihm nachgeschalteten Resonator-Schaltkreis, wobei

- ein erster Eingang des Operationsverstärkers mit dem zweiten Anschluss der Spule des vorgeschalteten Resonator-Schaltkreises gekoppelt ist;
- ein zweiter Eingang des Operationsverstärkers mit dessen Ausgang rückgekoppelt ist und mit dem ersten Anschluss des ohmschen Widerstands des dem vorgeschalteten Resonator-Schaltkreis nachgeschalteten Resonator-Schaltkreises gekoppelt ist.

11. Schaltkreis-Anordnung nach einem der Ansprüche 1 bis 10, bei welcher die Güte aller in Serie geschalteter Resonator-Schaltkreise identisch eingestellt ist.

12. Schaltkreis-Anordnung nach einem der Ansprüche 1 bis 10, bei welcher die Güte jeder der in Serie geschalteten Resonator-Schaltkreise individuell eingestellt ist.

13. Schaltkreis-Anordnung nach einem der Ansprüche 1 bis 12, mit einer Mehrzahl von parallel geschalteten Zweigen, von denen jeder eine Mehrzahl von in Serie miteinander geschalteten Resonator-Schaltkreise aufweist, wobei die Güte eines jeweiligen Resonator-Schaltkreises mittels des Steuer-Schaltkreises steuerbar ist.

14. Schaltkreis-Anordnung nach Anspruch 13, bei welcher die Resonator-Schaltkreise eines jeweiligen Zweiges derart eingerichtet sind, dass sie für einen jeweiligen Frequenzbereich des Eingabesignals durchlässig sind derart, dass die Zweige gemeinsam für ein zusammenhängendes Frequenzintervall durchlässig sind.

15. Schaltkreis-Anordnung nach Anspruch 14, bei der die Frequenzbereiche, für die die unterschiedliche Zweige durchlässig sind, zumindest teilweise einander überlappen.

**16.** Schaltkreis-Anordnung nach Anspruch 14 oder 15,
bei welcher der Frequenzbereich, für den ein jeweiliger Zweig durchlässig ist, mittels Einstellens des Werts der Kapazität und/oder der Induktivität der Resonator-Schaltkreise des Zweiges vorgebbar ist.

**17.** Schaltkreis-Anordnung nach einem der Ansprüche 1 bis 16, die zum Verarbeiten eines akustischen Signals als Eingabesignal eingerichtet ist.

**18.** Signalverarbeitungs-Vorrichtung

- mit einer Schaltkreis-Anordnung nach einem der Ansprüche 1 bis 17;
- mit einer Weiterverarbeitungs-Einheit zum Weiterverarbeiten des Ausgabesignals.

**19.** Signalverarbeitungs-Vorrichtung nach Anspruch 18,
bei der die Weiterverarbeitungs-Einheit

- eine Spracherkennungs-Einrichtung; oder
- ein Hörgerät;

ist.

**20.** Signalverarbeitungs-Vorrichtung nach Anspruch 15 oder 16, eingerichtet als analoge Filterbank oder als digitale Filterbank.

**Claims**

**1.** A circuit arrangement, comprising:

- a plurality of series-connected resonator circuits, it being possible for an output signal of a resonator circuit that is respectively connected upstream to be provided as an input signal to the resonator circuit that is respectively connected downstream thereof, each resonator circuit being set up to generate an output signal from an input signal and comprising:

-- a capacitance and an inductance,
-- an input at which the input signal can be provided,
-- an output at which the output signal can be provided;

- a control circuit for the open-loop or closed-loop control of the quality factor of the resonator circuits, the control circuit being set up in such a way that it controls the quality factor of the resonator circuits in an open-loop manner or in a closed-loop manner depending on the signal profile of the signal amplitude of the input signal and/or of the output signal.

**2.** The circuit arrangement as claimed in claim 1,
in which the resonator circuits have a nonreactive resistance that can be controlled by means of the control circuit.

**3.** The circuit arrangement as claimed in claim 2,
in which

- the input signal can be provided between a first terminal of the nonreactive resistance and a first terminal of the capacitance;
- the output signal can be provided between the first terminal of the capacitance and a second terminal of the capacitance;
- a second terminal of the nonreactive resistance is coupled to a first terminal of the inductance and a second terminal of the inductance is coupled to the second terminal of the capacitance.

**4.** The circuit arrangement as claimed in one of claims 1 to 3,
in which the control circuit is set up in such a way that it controls the quality factor of the resonator circuits based on a Boltzmann function and/or the derivative thereof, the Boltzmann function containing the amplitude of the output signal as a parameter.

5. The circuit arrangement as claimed in one of claims 1 to 4,
in which the control circuit is set up in such a way that it sets the quality factor of the resonator circuits in a manner dependent on the amplitude of the output signal based on a sensitivity characteristic determined for an ear of a human being.

6. The circuit arrangement as claimed in one of claims 1 to 5,
in which the control circuit is set up in such a way that it sets the quality factor of the resonator circuits to be lower, the higher the amplitude of the output signal.

7. The circuit arrangement as claimed in claim 6,
in which the control circuit is set up in such a way that it sets the quality factor of the resonator circuits in a nonlinear dependence on the amplitude of the output signal.

8. The circuit arrangement as claimed in one of claims 1 to 7,
in which the control circuit is set up in such a way that it sets the quality factor of the resonator circuits in such a way that the amplitude of the output signal is within a predetermined interval.

9. The circuit arrangement as claimed in one of claims 1 to 8,
in which the second terminal of the coil of a resonator circuit connected upstream is coupled to the first terminal of the nonreactive resistance of the resonator circuit connected downstream of the resonator circuit connected upstream.

10. The circuit arrangement as claimed in one of claims 1 to 8,
comprising an operational amplifier between a resonator circuit connected upstream and the resonator circuit connected downstream thereof,

 - a first input of the operational amplifier being coupled to the second terminal of the coil of the resonator circuit connected upstream;
 - a second input of the operational amplifier being feedback-coupled to the output thereof and being coupled to the first terminal of the nonreactive resistance of the resonator circuit connected downstream of the resonator circuit connected upstream.

11. The circuit arrangement as claimed in one of claims 1 to 10,
in which the quality factor of all the series-connected resonator circuits is set in identical fashion.

12. The circuit arrangement as claimed in one of claims 1 to 10,
in which the quality factor of each of the series-connected resonator circuits is set in individual fashion.

13. The circuit arrangement as claimed in one of claims 1 to 12,
comprising a plurality of parallel-connected branches, each of which has a plurality of series-connected resonator circuits, it being possible for the quality factor of a respective resonator circuit to be controlled by means of the control circuit.

14. The circuit arrangement as claimed in claim 13,
in which the resonator circuits of a respective branch are set up in such a way that they are transmissive for a respective frequency range of the input signal in such a way that the branches are jointly transmissive for a contiguous frequency interval.

15. The circuit arrangement as claimed in claim 14,
in which the frequency ranges for which the different branches are transmissive overlap one another at least partially.

16. The circuit arrangement as claimed in claim 14 or 15,
in which the frequency range for which a respective branch is transmissive can be predefined by means of setting the value of the capacitance and/or the inductance of the resonator circuits of the branch.

17. The circuit arrangement as claimed in one of claims 1 to 16,

which is set up for processing an acoustic signal as input signal.

**18.** A signal processing device

   - comprising a circuit arrangement as claimed in one of claims 1 to 17;
   - comprising a further processing unit for further processing of the output signal.

**19.** The signal processing device as claimed in claim 18, in which the further processing unit is

   - a speech recognition device; or
   - a hearing aid.

**20.** The signal processing device as claimed in claim 15 or 16,
set up as an analog filter bank or as a digital filter bank.

**Revendications**

**1.** Montage,

   - comprenant une multiplicité de circuits résonateurs montés en série, un signal de sortie d'un circuit résonateur, respectivement en amont, pouvant être mis à disposition en tant que signal d'entrée, respectivement d'un circuit résonateur en aval, chaque circuit résonateur étant conçu pour produire un signal de sortie à partir d'un signal d'entrée et ayant :

      -- une capacité et une inductance,
      -- une entrée à laquelle le signal d'entrée est disponible,
      -- une sortie à laquelle le signal de sortie est disponible ;

   - comprenant un circuit de commande pour commander ou réguler la qualité des circuits résonateurs, le circuit de commande étant tel qu'il commande ou régule la qualité des circuits résonateurs en fonction de la courbe des amplitudes du signal d'entrée et/ou du signal de sortie.

**2.** Montage suivant la revendication 1,
dans lequel les circuits résonateurs ont une résistance ohmique pouvant être réglée au moyen du circuit de commande.

**3.** Montage suivant la revendication 2,
dans lequel

   - le signal d'entrée est disponible entre une première borne de la résistance ohmique et une première borne de la capacité ;
   - le signal de sortie est disponible entre la première borne de la capacité et une deuxième borne de la capacité ;
   - une deuxième borne de la résistance ohmique et relié à une première borne de l'inductance et une deuxième borne de l'inductance à la deuxième borne de la capacité.

**4.** Montage suivant l'une des revendications 1 à 3,
dans lequel le circuit de commande est tel qu'il règle la qualité des circuits résonateurs sur la base d'une fonction de Boltzmann et/ou de sa dérivée, la fonction de Boltzmann contenant comme paramètre l'amplitude du signal de sortie.

**5.** Montage suivant l'une des revendications 1 à 4,
dans lequel le circuit de commande est tel qu'il règle la qualité du circuit résonateur en fonction de l'amplitude du signal de sortie sur la base d'une caractéristique de sensibilité déterminée pour une oreille humaine.

**6.** Montage suivant l'une des revendications 1 à 5,
dans lequel le circuit de commande est tel qu'il règle la qualité des circuits résonateurs à une valeur d'autant plus petite que l'amplitude du signal de sortie est plus grande.

**7.** Montage suivant la revendication 6,
dans lequel le circuit de commande est tel qu'il règle la qualité des circuits résonateurs suivant une dépendance non linéaire de l'amplitude du signal de sortie.

**8.** Montage suivant l'une des revendications 1 à 7,
dans lequel le circuit de commande est tel qu'il règle la qualité des circuits résonateurs de façon à ce que l'amplitude du signal de sortie se trouve dans un intervalle déterminé à l'avance.

**9.** Montage suivant l'une des revendications 1 à 8,
dans lequel la deuxième borne de la bobine d'un circuit résonateur en amont est reliée à la première borne de la résistance ohmique du circuit résonateur en aval du circuit résonateur en amont.

**10.** Montage suivant l'une des revendications 1 à 8,
comprenant un amplificateur opérationnel entre un circuit résonateur en amont et le circuit résonateur qui en est en aval, dans lequel

- une première entrée de l'amplificateur opérationnel est reliée à la deuxième borne de la bobine du circuit résonateur en amont ;
- une deuxième entrée de l'amplificateur opérationnel est reliée en réaction à sa sortie et reliée à la première borne de la résistance ohmique du circuit résonateur en aval du circuit résonateur en amont.

**11.** Montage suivant l'une des revendications 1 à 10,
dans lequel la qualité de tous les circuits résonateurs montés en série est identique.

**12.** Montage suivant l'une des revendications 1 à 10,
dans lequel la qualité de chacun des circuits résonateurs montés en série est réglée individuellement.

**13.** Montage suivant l'une des revendications 1 à 12,
comprenant une multiplicité de branches montées en parallèle dont chacune a une multiplicité de circuits résonateurs montés en série entre eux, la qualité d'un circuit résonateur respectif pouvant être réglée au moyen du circuit de commande.

**14.** Montage suivant la revendication 13,
dans lequel les circuits résonateurs d'une branche respective sont tels qu'ils laissent passer un domaine de fréquence respectif du signal d'entrée de façon à ce que les branches laissent passer conjointement un intervalle de fréquence continue.

**15.** Montage suivant la revendication 14,
dans lequel les domaines de fréquence dans lesquels les branches différentes sont passantes se chevauchent au moins en partie.

**16.** Montage suivant la revendication 14 ou 15,
dans lequel le domaine de fréquence, dans lequel une branche respective est passante, peut être prescrit au moyen d'un réglage de la valeur de la capacité et/ou de l'inductance des circuits résonateurs de la branche.

**17.** Montage suivant l'une des revendications 1 à 16,
qui est conçu pour le traitement d'un signal acoustique comme signal d'entrée.

**18.** Dispositif de traitement du signal

- comprenant un montage suivant l'une des revendications 1 à 17 ;
- comprenant une unité de retraitement pour retraiter le signal de sortie.

**19.** Dispositif de traitement du signal suivant la revendication 18,
dans lequel l'unité de retraitement est

- un dispositif de reconnaissance de la parole ; ou
- une prothèse auditive.

20. Dispositif de traitement du signal suivant la revendication 15 ou 16, agencé en banc de filtre analogique ou en banc de filtre numérique.

## FIG 1

## FIG 2

## FIG 3

FIG 4

FIG5

# FIG 6A

# FIG 6B

FIG 7A

FIG 7B

EP 1 540 818 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3808540 A

- DE 2401816 C2

**In der Beschreibung aufgeführte Nicht-Patentliteratur**

- Automatische Spracherkennung. **Schukat-Talamazzini, EG.** Braunschweig/Wiesbaden. Friedrich Vieweg & Sohn Verlagsgesellschaft

- **Ruggero, MA et al.** Mechanical bases of frequency tuning and neural excitation at the base of the cochlea: comparison of basilar-membrane vibrations and auditory nerve-fiber responses in chinchilla. *Proc.Natl.Acad. Sci. USA,* 2000, vol. 97 (22), 11744-11750